# EUROPÄISCHE PATENTSCHRIFT

(11) **EP 1 746 183 B1**
(45) Veröffentlichungstag und Bekanntmachung des Hinweises auf die Patenterteilung: **27.01.2010**
(21) Anmeldenummer: 06014020.9
(22) Anmeldetag: 06.07.2006
(51) Int. Cl.: C23C 16/34, H01L 21/285

(54) **Verfahren zur Herstellung dünner Zirkoniumnitrid-Schichten**
Process for obtaining thin films of zirconium nitride
Procédé d'obtention de couches minces de nitrure de zirconium

(30) Priorität: 19.07.2005 DE 102005033579
(43) Veröffentlichungstag der Anmeldung: 24.01.2007
(73) Patentinhaber: H.C. Starck Clevios GmbH, 38642 Goslar (DE)
(72) Erfinder: Reuter, Knud, Dr., 47800 Krefeld (DE); Passing, Gerd, Dr., 50354 Hürth (DE); Younsoo, Kim, Dr. Geumhwa Maeul Jugong Ap. 408-401, Gyeonggi-Do 449-958 (KR); Harish, Parala, Dr., 44791 Bochum (DE); Fischer, Roland A., Prof. Dr., 44879 Bochum (DE)
(74) Vertreter: Herzog, Martin

(56) Entgegenhaltungen:
- EP-A- 1 152 066
- EP-A2- 0 174 743
- WO-A-91/08322
- US-A1- 2002 182 320
- WENDEL H ET AL: "THIN ZIRCONIUM NITRIDE FILMS PREPARED BY PLASMA-ENHANCED CVD" APPLIED PHYSICS A. SOLIDS AND SURFACES, SPRINGER VERLAG. HEIDELBERG, DE, Bd. A54, Nr. 4, April 1992 (1992-04), Seiten 389-392, XP009075117 ISSN: 0721-7250
- FIX R ET AL: "CHEMICAL VAPOR DEPOSITION OF TITANIUM, ZIRCONIUM, AND HAFNIUM NITRIDE THIN FILMS" CHEMISTRY OF MATERIALS, AMERICAN CHEMICAL SOCIETY, WASHINGTON, US, Bd. 3, Nr. 6, 1. November 1991 (1991-11-01), Seiten 1138-1148, XP000276044 ISSN: 0897-4756
- SUGIYAMA K., PAC S., TAKAHASHI Y.,MOTOJIMA S.: "Low Temperature Deposition of Metal Nitrides by Thermal Decomposition of Organometallic Compounds" JOURNAL OF THE ELECTROCHEMICAL SOCIETY, Bd. 122, Nr. 11, November 1975 (1975-11), Seiten 1545-1549, XP002408524
- MYUNG BOK LEE ET AL: "Epitaxial growth of highly crystalline and conductive nitride films by pulsed laser deposition" JAPANESE JOURNAL OF APPLIED PHYSICS, PART 1 (REGULAR PAPERS & SHORT NOTES) JAPAN, Bd. 33, Nr. 11, November 1994 (1994-11), Seiten 6308-6311, XP002408525 ISSN: 0021-4922

## Beschreibung

Die vorliegende Erfindung betrifft ein Verfahren zur Herstellung dünner Zirkoniumnitrid(ZrN)-Schichten mit Hilfe der Technik der MOCVD (Metalorganic Chemical Vapour Deposition).

Wegen der zunehmenden Verkleinerung der Dimensionen in mikroelektronischen Bauteilen bis zu < 100 nm wird es immer wichtiger, Elemente mit ausreichender elektrischer Kapazität erzielen zu können Bis heute werden für mikroelektronische Bauteile Siliziumdioxid (SiO₂) und sog. PolySilizium (p-Si) als Dieletrikum bzw. Elektrodenmaterial benutzt. Diese Kombination zeigt ausgezeichnete physikalische, insbesondere elektrische Eigenschaften, da beide Materialien auf Si basieren. Während für Zirkoniumoxid aus jüngsten Untersuchungen vor allem eine sehr hohe Dielektrizitätskonstante k belegt ist, richtet sich das Interesse zuletzt vermehrt auf Zirkoniumnitrid (ZrN) wegen seiner neuen Eigenschaftskombination aus hoher Dielektrizitätskonstante und Eignung als Elektrodenmaterial. Außerdem wurde ZrN wegen seiner guten elektrischen Leitfähigkeit, seines hohen Schmelzpunkts, sowie seiner großen Härte und Dichte als Diffusionsbarriere und Beschichtungsmaterial benutzt (siehe Chen, Cheng-Shi; Liu, Chuan-Pu; Yang, Heng-Ghieh; Tsao, Chi Y. A., Journal of Vacuum Science & Technology, B (2004), 22(3), 1075-1083). ZrN-Schichten wurden bisher mittels des PVD-Verfahrens (Physical Vapor Deposition) hergestellt. Allerdings weisen ZrN-Filme, die durch PVD abgeschieden wurden, wegen schlechter Haftung im Allgemeinen eine inhärent mäßige Stufenabdeckung des Substrates auf, weshalb ihre zukünftigen Anwendungen in der Mikroelektronik begrenzt erscheinen. Hoffman *et al.* versuchten, durch das MOCVD-Verfahren (metal organic chemical vapor deposition) Filme aus ZrN abzuscheiden (siehe D. M. Hoffman, Polyhedron, 13, 1169 (1994) und R. Fix, R. G. Gordon, and D. M. Hoffman, Chem. Mater., 3, 1138 (1991)). Jedoch wurden in diesen Arbeiten ausschließlich elektrisch nicht leitfähige Zr₃N₄-Schichten erzeugt, da für Zr die Oxidationsstufe +4 die bei weitem stabilste Oxidationsstufe darstellt. Bis heute konnten offenbar leitfähige ZrN-Schichten noch nicht mittels chemischer Gasphasenabscheidung hergestellt werden. Zirkonium wird in Fachkreisen oft und daher auch gegebenenfalls im Folgenden kurz als Zirkon bezeichnet.

Aufgabe der Erfindung war es, Zirkoniumnitrid-Schichten mittels eines neuen Verfahren zu erzeugen, das die Nachteile des Standes der Technik nicht aufweist.

In der vorliegenden Erfindung werden Zirkoniumtetrakis(dialkylamid)e Zr(N-R¹R²)₄ (worin R¹, R² insbesondere = Me, Et bedeuten) als Vorläuferverbindungen (nachstehend auch Prekursoren genannt) und Methylhydrazin (MHy, MeHNNH₂) und/oder N,N-Dimethylhydrazin (DMHy, Me₂NNH₂) als Reaktivgas eingesetzt.

Gegenstand der Erfindung ist ein Verfahren zur Herstellung von Zirkoniumnitrid (ZrN)-Schichten mittels des CVD-Verfahrens (chemical vapour deposition) aus einem Reaktivgas auf einer Substratoberfläche, dadurch gekennzeichnet, dass ein Zirkonium-tetrakis(dialkylamid) der allgemeinen Formel

Zr(NR¹R²)₄

wobei R¹ und R² gleiche oder verschiedene, geradkettige oder verzweigte C₁- bis C₄-Alkylreste bedeuten, als Zr-Prekursor
und ein Hydrazinderivat der allgemeinen Formel

H₂N-NR³R⁴

wobei R³ einen geradkettigen oder verzweigten C₁- bis C₄-Alkylrest und R⁴ unabhängig davon einen C₁- bis C₄-Alkylrest oder H bedeuten,
als Reaktivgas verwendet werden.

Die Reaktion des Zr-Prekursors und des Hydrazinderivats während der MOCVD läuft nach gegenwärtiger Vorstellung wie im folgenden grob skizziert: Das Hydrazinderivat reagiert mit dem Prekursor auf der Substratoberfläche unter Bildung von ZrN und flüchtigen Nebenprodukten, wie HNRR', HNMe₂ oder H₂NMe, und N₂. Entfernt man die flüchtigen Nebenprodukte z.B. mittels einer Vakuumpumpe aus der Reaktionskammer, entsteht die hochkristalline dünne ZrN-Schicht. Die Reaktionsschemen sind für die Zr-Schicht beispielsweise:

Zr(NRR')₄ + 4 Me₂NNH₂ → ZrN + 4 HNRR' + 4 HNMe₂ + 3/2 N₂, (5)

Zr(NRR')₄ + 4 MeHNNH₂ → ZrN + 4 HNRR' + 4 H₂NMe + 3/2 N₂, (6)

R, R' = Me, Et

Bevorzugt ist ein Verfahren bei dem als Zirkoniumverbindung (Prekursor) Zirkonium-tetrakis(dimethylamid), Zirkonium-tetrakis(methylethylamid) oder Zirkonium-tetrakis(diethylamid) eingesetzt werden.

Bevorzugt ist weiterhin ein Verfahren, bei dem als Komponente im Reaktivgas unsymmetrisches Methylhydrazin und/oder unsymmetrisches Dimethylhydrazin (N,N-Dimethylhydrazin) eingesetzt werden.

Bevorzugt ist ein Verfahren bei dem das Substrat während der Reaktion auf eine Temperatur von 200 bis 1100°C, besonders bevorzugt auf eine Temperatur von 250 bis 1000°C gebracht wird

Vorteilhafterweise wird die Reaktion bevorzugt unter einem Druck von 10⁻³ bis 10 mbar, besonders bevorzugt von 10⁻² bis 1 mbar durchgeführt.

Zur Verbesserung der Schichthaftung wird die Substratoberfläche vor der Reaktion gereinigt, insbesondere durch reduktive Entfernung eventueller Oxidschichten.

Bevorzugt werden als Substrate in dem neuen Verfahren Halbleiter oder strukturierte Halbleiter eingesetzt, insbesondere solche auf Basis von Si, Ge, GaAs, GaN oder SiC.

Gegenstand der Erfindung sind ferner eine ZrN-Schicht hergestellt nach dem erfindungsgemäßen Verfahren und ein Substrat aufweisend eine solche ZrN-Schicht

Die neuen ZrN-Schichten finden Verwendung als Gate-Metall in Halbleiterstrukturen, insbesondere in integrierten Schaltungen oder als elektrisch leitende Schicht in elektronischen Bauelementen, insbesondere in Kondensatoren oder integrierten Schaltungen.

Eine weitere Verwendung der neuen ZrN-Schichten besteht in der Oberflächenhärtung von Metallen, insbesondere für Werkzeugoberflächen.

### Beispiele

Allg. Verfahren: Für die Abscheidung einer ZrN-Dünnschicht wurde ein vertikaler CVD-Reaktor benutzt. Die Reaktionskammer des Reaktors wurde mit Hilfe einer Drehschieberpumpe und einer Turbomolekularpumpe evakuiert. Der Zr-Prekursor und der Reaktivzusatz (DMHy oder MHy) wurden in verschiedene Waschflaschen eingefüllt. Die Waschflasche mit dem Zr-Prekursor wurde mit einem Wasser-Heizmantel auf konstante Temperatur gebracht. Ein- und Auslass der Waschflasche wurden mit der Trägergas-Leitung bzw. dem CVD-Reaktor verbunden. Der Trägergas-Strom wurde automatisch mit einem Durchflussmessgerät kontrolliert. Der Prekursor mit dem Trägergas und der Reaktivkomponente wurde vertikal durch ein ¼-Zoll-Stahlrohr auf das 1,0 x 2,0 cm² große Substrat geleitet. Alle Verbindungen zwischen Waschflasche und Reaktorkammer wurden auf 110°C erhitzt. Die Substratoberflächen wurden nach einer in Lit. A. Ishizaka and Y. Shiraki, J. Electrochem. Soc., 133, 666 (1986) beschriebenen Methode gereinigt und in die Reaktionskammer eingeführt. Die Substrattemperatur wurde mit einem Thermoelement kontrolliert und auf den gewünschten Wert zwischen 200 und 1000°C eingestellt.

**Beispiel CVD 1:** Zr(NMeEt)₄ und MHy wurden in einer Handschuh-Box in die Waschflasche eingefüllt. Der Druck in der Reaktivkammer betrug 1,0 × 10⁻⁵ mbar. Zur Entfernung der ursprünglichen Siliziumoxid-Schicht wurde das Substrat vor dem Abscheidungsprozess ca. 30 min unter Wasserstoffgas auf 950°C erhitzt. Nach der Entfernung der Oxidschicht wurde die ZrN-Abscheidung bei 800 - 850°C während 30 min durchgeführt. Während der Abscheidung waren die Waschflaschen gegen die Kammer geöffnet und auf 23°C temperiert. Ein Stickstoff-Trägergasstrom von 10 sccm wurde durch die Waschflasche mit dem Zr-Prekursor geleitet; der Druck in der Reaktionskammer betrug während der Reaktion 0,05 mbar.

Ein gut haftender ZrN-Film wurde auf dem Si-Substrat abgeschieden. Als spezifischer elektrischer Widerstand der Schicht wurde 6000 µΩcm gemessen. Röntgendiffraktometrie und SEM-Aufnahmen (Scanning Electron Microscopy) belegen die Abscheidung einer kubischen, kristallinen ZrN-Schicht.

## Patentansprüche

1. Verfahren zur Herstellung von Zirkoniumnitrid(ZrN)-Schichten mittels des CVD-Verfahrens (chemical vapour deposition) aus einem Reaktivgas auf einer Substratoberfläche **dadurch gekennzeichnet, dass** ein Zirkonium-tetrakis(dialkylamid) der allgemeinen Formel
Zr(NR¹R²)₄
wobei R¹ und R² gleiche oder verschiedene, geradkettige oder verzweigte C₁- bis C₄-Alkylreste bedeuten, als Zr-Prekursor
und ein Hydrazinderivat der allg. Formel
H₂N-NR³R₄
wobei R³ einen geradkettigen oder verzweigten C₁- bis C₄-Alkylrest und R⁴ unabhängig davon einen C₁- bis C₄-Alkylrest oder H bedeuten,
als Reaktivgas verwendet werden.

2. Verfahren gemäß Anspruch 1, **dadurch gekennzeichnet, dass** als Zirkoniumverbindung Zirkonium-tetrakis(dimethylamid), Zirkonium-tetrakis(methylethylamid) oder Zirkoniumtetrakis(diethylamid) eingesetzt werden.

3. Verfahren gemäß einem der Ansprüche 1 oder 2, **dadurch gekennzeichnet, dass** als Komponente im Reaktivgas unsymmetrisches Methylhydrazin und/oder unsymmetrisches Dimethylbydrazin (N,N-Dimethymydrazin) eingesetzt werden.

4. Verfahren nach einem der Ansprüche 1 bis 3, **dadurch gekennzeichnet, dass** das Substrat während der Reaktion auf eine Temperatur von 200 bis 1100°C, bevorzugt auf eine Temperatur von 250 bis 1000°C gebracht wird.

5. Verfahren nach einem der Ansprüche 1 bis 4, **dadurch gekennzeichnet, dass** die Reaktion unter einem Druck von 10⁻³ bis 10 mbar, bevorzugt von 10⁻² bis 1 mbar durchgeführt wird.

6. Verfahren nach einem der Ansprüche 1 bis 5, **dadurch gekennzeichnet, dass** als Substrate Halbleiter oder strukturierte Halbleiter eingesetzt werden, insbesondere solche auf Basis von Si, Ge, GaAs, GaN oder SiC.

## Claims

1. Process for production of zirconium nitride (ZrN) layers by means of the CVD process (chemical vapour deposition) from a reactive gas on a substrate surface, **characterised in that** a zirconium tetrakis(dialkylamide) of the general formula
Zr(NR¹R²)₄
wherein R¹ and R² are the same or different, straight chain or branched C₁ to C₄ alkyl residues, as Zr precursor
and a hydrazine derivative of the general formula
H₂N-NR³R₄
wherein R³ is a straight chain or branched C₁ to C₄ alkyl residue and R⁴ independently thereof is a C₁ to C₄ alkyl residue or H,
are used as reactive gas.

2. Process according to claim 1, **characterised in that** as zirconium compound zirconium tetrakis(dimethylamide), zirconium tetrakis(methylethylamide} or zirconium tetrakis(diethylamide) are used.

3. Process according to any one of claims 1 or 2, **characterised in that** as component in the reactive gas unsymmetrical methylhydrazine and/or unsymmetrical dimethylhydrazine (N,N-dimethylhydrazine) are used.

4. Process according to any one of claims 1 to 3, **characterised in that** during the reaction the substrate is brought to a temperature of from 200 to 1100 °C, preferably to a temperature of from 250 to 1000 °C.

5. Process according to any one of claims 1 to 4, **characterised in that** the reaction is carried out under a pressure of 10⁻³ to 10 mbar, preferably from 10⁻² to 1 mbar.

6. Process according to any one of claims 1 to 5, **characterised in that** as substrates semiconductors or structured semiconductors are used, in particular those based on Si, Ge, GaAs, GaN or SiC.

## Revendications

1. Procédé destiné à la fabrication de couches de nitrure de zirconium (ZrN) au moyen du procédé CVD (dépôt chimique en phase vapeur = chemical vapour deposition) d'un gaz réactif sur une surface de substrat, **caractérisé en ce qu'**un zirconium-tetrakis(dialkylamide), ayant la formule générale
Zr(NR¹R²)₄,
R¹ et R² signifiant des restes d'alkyle C₁ à C₄ égaux ou différents, linéaires ou ramifiés sont utilisés comme précurseur de Zr et un dérivé de hydrazine, ayant la formule générale
H²N-NR³R₄,
R³ signifiant un reste d'alkyle C₁ à C₄ linéaire ou ramifié et R⁴ indépendamment de ces derniers un reste d'alkyle C₁ à C₄ ou de H, sont utilisés comme gaz réactif.

2. Procédé selon la revendication 1, **caractérisé en ce que** comme composé de zirconium on utilise du zirconium-tetrakis(dimethylamide), du zirconium-tetrakis(methylethylamide) ou du zirconium-tetrakis(diethylamide).

3. Procédé selon l'une des revendications 1 ou 2, **caractérisé en ce qu'**en tant que composant dans le gaz réactif on utilise de la méthylhydrazine asymétrique et/ou de la dimethylhydrazine asymétrique (N,N-dimefhylhydrazine).

4. Procédé selon l'une des revendications 1 à 3, **caractérisé en ce que** durant la réaction le substrat est porté à une température de 200 à 1100°C, de préférence à une température de 250 à 1000 °C.

5. Procédé selon l'une des revendications 1 à 4, **caractérisé en ce que** la réaction est exécutée sous une pression de 10⁻³ à 10 mbar, de préférence de 10⁻² à 1 mbar.

6. Procédé selon l'une des revendications 1 à 5, **caractérisé en ce que** comme substrats on utilise des semi-conducteurs ou des semi-conducfeurs structurés, notamment ceux à base de Si, Ge, GaAs, GaN ou SiC.
